(19) Europäisches Patentamt
European Patent Office
Office européen des brevets

(11) **EP 3 784 613 B1**

(12) **EUROPÄISCHE PATENTSCHRIFT**

(45) Veröffentlichungstag und Bekanntmachung des Hinweises auf die Patenterteilung:
**27.12.2023 Patentblatt 2023/52**

(21) Anmeldenummer: **19715938.7**

(22) Anmeldetag: **11.04.2019**

(51) Internationale Patentklassifikation (IPC):
**B66B 1/34** (2006.01)   **B66B 3/02** (2006.01)

(52) Gemeinsame Patentklassifikation (CPC):
**B66B 1/3492**

(86) Internationale Anmeldenummer:
**PCT/EP2019/059175**

(87) Internationale Veröffentlichungsnummer:
**WO 2019/206644 (31.10.2019 Gazette 2019/44)**

(54) **POSITIONSBESTIMMUNGSSYSTEM UND VERFAHREN ZUR ERMITTLUNG EINER KABINENPOSITION EINER AUFZUGKABINE**

POSITION DETERMINING SYSTEM AND METHOD FOR DETERMINING A POSITION OF AN ELEVATOR CAR

SYSTÈME DE DÉTERMINATION DE POSITION ET PROCÉDÉ DE DÉTERMINATION D'UNE POSITION DE CABINE D'UNE CABINE D'ASCENSEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.04.2018 EP 18169048**

(43) Veröffentlichungstag der Anmeldung:
**03.03.2021 Patentblatt 2021/09**

(73) Patentinhaber: **INVENTIO AG**
**6052 Hergiswil (CH)**

(72) Erfinder:
• **BIRRER, Eric**
**6033 Buchrain (CH)**
• **ROUSSEL, Frank Olivier**
**6006 Luzern (CH)**

(74) Vertreter: **Inventio AG**
**Seestrasse 55**
**6052 Hergiswil (CH)**

(56) Entgegenhaltungen:
EP-A1- 1 634 841     EP-A1- 1 637 493
EP-A1- 2 189 410     EP-B1- 1 412 274

**Beschreibung**

Die Erfindung betrifft ein Positionsbestimmungssystem zur Ermittlung einer Kabinenposition einer in einem Aufzugschacht verfahrbaren Aufzugkabine gemäss dem Oberbegriff des Anspruchs 1 und ein Verfahren zur Ermittlung einer Kabinenposition einer in einem Aufzugschacht verfahrbaren Aufzugkabine gemäss dem Oberbegriff des Anspruchs 10.

Die EP 1412274 B1 beschreibt ein Positionsbestimmungssystem und ein Verfahren zur Ermittlung einer Kabinenposition einer in einem Aufzugschacht verfahrbaren Aufzugkabine. Das Positionsbestimmungssystem weist ein parallel zu einer Verfahrrichtung neben der Aufzugskabine angebrachtes Codemarkenmuster auf, wobei n aufeinanderfolgende Codemarken des Codemarkenmusters eine Positionsmarke bilden. Die Codemarken bilden dabei magnetische Pole, so dass das Codemarkenmuster aus einer Reihe von magnetischen Nord- und Südpolen aufgebaut ist. Die Positionsmarken sind in einer n-stelligen Pseudozufallsfolge verschiedener Positionsmarken eindeutig angeordnet, wobei die Positionsmarken ein einspuriges Codemarkenmuster bilden. Jeder der genannten Positionsmarke ist über eine Zuordnungstabelle eine diskrete Kabinenposition zugeordnet.

Das Positionsbestimmungssystem verfügt über eine an der Fahrzeugkabine angeordnete Erfassungsvorrichtung, welche eine komplette Positionsmarke auf einmal erfassen kann. Die Erfassungsvorrichtung weist dazu eine Reihe von Hall-Sensoren auf, welche das Codemarkenmuster berührungslos abtasten und so die Positionsmarke erfassen. Die Anzahl und die Anordnung der Hall-Sensoren ist dabei so gewählt, dass sich eine Erfassungs-Länge eines Erfassungsbereichs der Erfassungsvorrichtung über mindestens eine Positionsmarken-Länge einer Positionsmarke in Verfahrrichtung erstreckt. Es ist damit möglich, sofort nach einem Neustart des Positionsbestimmungssystems eine komplette Positionsmarke zu erfassen.

Das Positionsbestimmungssystem verfügt ausserdem über eine Auswerteeinheit, welche auf Basis der von der Erfassungsvorrichtung erfassten Positionsmarke eine Kabinenposition bestimmt. Es ist damit möglich, sofort nach einem Start des Positionsbestimmungssystems die Kabinenposition zu bestimmen. Um eine besonders sichere Bestimmung der Kabinenposition der Aufzugkabine zu ermöglichen, ist beim Positionsbestimmungssystem der EP 1412274 B1 die Bestimmung der Kabinenposition vollständig redundant ausgeführt. Damit ist eine Vielzahl von Hall-Sensoren notwendig, bei einem Ausführungsbeispiel der EP 1412274 B1 insgesamt 32 Hall-Sensoren. Dies führt dazu, dass für das Positionsbestimmungssystem der EP 1412274 B1 gewisse Materialkosten notwendig sind und die Unterbringung der Hall-Sensoren in der Erfassungsvorrichtung einen gewissen Bauraum beansprucht. Dieser Aufwand ist insbesondere dann gerechtfertigt, wenn das so aufgebaute Positionsbestimmungssystem als einziges und damit sicherheitsrelevantes Positionsbestimmungssystem verwendet wird.

Die EP 1634841 A1 und die EP 1637493 A1 beschreiben ebenfalls Positionsbestimmungssysteme zur Ermittlung einer Kabinenposition einer in einem Aufzugschacht verfahrbaren Aufzugkabine, welche ebenfalls Positionsmarken zu einem Zeitpunkt vollständig erfassen können.

Die WO 2013/182644 A1 beschreibt ein inkrementelles Verfahren zur Wegstreckenmessung.

Demgegenüber ist es insbesondere die Aufgabe der Erfindung, ein Positionsbestimmungssystem und ein Verfahren zur Ermittlung einer Kabinenposition einer Aufzugkabine vorzuschlagen, welche besonders einfach und damit kostengünstig realisiert werden können. Erfindungsgemäss wird diese Aufgabe mit einem Positionsbestimmungssystem mit den Merkmalen des Anspruchs 1 und einem Verfahren mit den Merkmalen des Anspruchs 10 gelöst.

Gemäss einem ersten Aspekt der Erfindung verfügt ein erfindungsgemässes Positionsbestimmungssystem zur Ermittlung einer Kabinenposition einer in einem Aufzugschacht verfahrbaren Aufzugkabine über ein parallel zu einer Verfahrrichtung neben der Aufzugskabine anbringbaren Codeband mit einem aus einzelnen Codemarken aufgebauten Codemarkenmuster, eine an der Aufzugkabine anbringbaren Erfassungsvorrichtung mit wenigstens einem Sensor zum Erfassen von Codemarken des Codemarkenmusters des Codebands und eine Auswerteeinheit zur Bestimmung der Kabinenposition auf Basis der von der Erfassungsvorrichtung erfassten Codemarken. Dabei bilden n aufeinanderfolgende Codemarken des Codemarkenmusters eine Positionsmarke, die Positionsmarken sind in einer n-stelligen Pseudozufallsfolge verschiedener Positionsmarken eindeutig angeordnet, die Positionsmarken bilden ein einspuriges Codemarkenmuster und jeder Positionsmarke ist eine diskrete Kabinenposition zuordnenbar ist.

Erfindungsgemäss weist ein Erfassungsbereich der Erfassungsvorrichtung eine Erfassungs-Länge in Verfahrrichtung auf, welche kleiner ist als eine Positionsmarken-Länge einer Positionsmarke in Verfahrrichtung. Die Erfassungsvorrichtung erstreckt sich damit in Verfahrrichtung nicht entlang einer kompletten Positionsmarke. Damit kann die Erfassungsvorrichtung gleichzeitig nur einen Teil einer Positionsmarke und somit keine komplette Positionsmarke auf einmal erfassen. Die Erfassungsvorrichtung muss damit vorteilhafterweise nur wenige Sensoren aufweisen. Die Erfassungsvorrichtung ist damit sehr kostengünstig herstellbar und beansprucht nur wenig Bauraum.

Die Erfassungsvorrichtung weist wenigstens vier, insbesondere sechs in Verfahrrichtung hintereinander angeordnete Sensoren auf. Damit ist eine besonders genaue Bestimmung der Kabinenposition möglich.

Unter der Erfassungs-Länge der Erfassungsvorrichtung in Verfahrrichtung soll hier die räumliche Ausdehnung eines Erfassungsbereichs in Verfahrrichtung verstanden werden, in dem die Erfassungsvorrichtung die Codemarken erfassen kann. Da die Erfassungsvorrichtung mehrere Sensoren aufweist, wird der Erfassungsbereich von den jeweils äussersten Sensoren in Verfahrrichtung begrenzt. Vereinfachend kann davon ausgegangen werden, dass die Erfassungsvorrichtung nur genau im Bereich der räumlichen Ausdehnung des Erfassungsbereichs in Verfahrrichtung die Codemarken erfassen kann.

Die Positionsmarken-Länge einer Positionsmarke in Verfahrrichtung ergibt sich aus dem Produkt einer Codemarken-Länge einer Codemarke und der Anzahl von Codemarken, aus denen eine Positionsmarke zusammengesetzt ist.

Die Auswerteeinrichtung ist insbesondere dazu vorgesehen, bei einem Verlagern der Erfassungsvorrichtung gegenüber dem Codeband in Verfahrrichtung eine erfasste Positionsmarke aus nacheinander erfassten Codemarken des Codemarkenmusters zusammenzusetzen. Sobald die Auswerteeinrichtung während dem genannten Verlagern der Aufzugkabine eine komplette Positionsmarke zusammengesetzt hat, kann sie aus der genannten Zuordnungstabelle auch die Kabinenposition bestimmen. Die dafür notwendige Verlagerung der Aufzugkabine ist dabei abhängig von der Positionsmarken-Länge in Verfahrrichtung. Bei einer Codemarkenlänge von 4 mm und einer Anzahl von 5 Codemarken pro Positionsmarke kann die notwendige Verlagerung beispielsweise maximal 20 mm betragen. Damit kann das Positionsbestimmungssystem nach einem Neustart, also insbesondere nach einem Einschalten einer Energieversorgung und damit ohne Kenntnis der letzten Kabinenposition vor einem Ausschalten der Energieversorgung die Kabinenposition erst bestimmen, wenn die Aufzugkabine ausreichend in Verfahrrichtung verlagert wurde.

Die Fahrtrichtung, also ob die Aufzugkabine nach oben oder nach unten verlagert wird, kann aus der Phasenlage von Signalen zweier voneinander beabstandeten Sensoren bestimmt werden. Die Sensoren haben dabei insbesondere einen Abstand einer halben Codemarken-Länge voneinander. Das Vorgehen ist dabei analog zum Vorgehen bei einer Drehrichtungserkennung.

Das Positionsbestimmungssystem basiert damit vorteilhafterweise auf einer bekannten und abgesicherten Technologie und ist zusätzlich durch die geringe Anzahl an notwendigen Sensoren kostengünstig herstellbar und benötigt einen geringen Bauraum in Verfahrrichtung.

Die Anmelderin hat dabei erkannt, dass es Einsatzgebiete für Positionsbestimmungssysteme gibt, bei denen eine sofortige Bestimmung der Kabinenposition nach einem Neustart nicht zwingend notwendig ist. Dies ist insbesondere dann der Fall, wenn die vom Positionsbestimmungssystem bestimmte Kabinenposition von einer Aufzugssteuerung nicht für die Steuerung oder Regelung der Verlagerung der Aufzugkabine genutzt wird, sondern zu Überwachungszwecken, wie beispielsweise zur Überwachung einer Anhaltegenauigkeit der Aufzugkabine an den verschiedenen Haltepunkten bzw. Stockwerken der Aufzuganlage. Für die Überwachung der Anhaltegenauigkeit können in einer Konfigurationsphase die einzelnen Haltestellen angefahren und die zugehörigen Kabinenpositionen gespeichert werden. In einer Überwachungsphase kann dann bei einem Halt an einer Haltestelle jeweils die aktuelle Kabinenposition mit der gespeicherten Kabinenposition verglichen werden. Die Ergebnisse der Überwachung können beispielsweise von einem Servicetechniker vor Ort ausgelesen oder an eine entfernte Überwachungszentrale übermittelt werden. Das Vorsehen eines zusätzlichen Positionsbestimmungssystems zu einem bereits vorhandenen Positionsbestimmungssystems für die Steuerung oder Regelung der Verlagerung der Aufzugkabine ist insbesondere dann notwendig bzw. sinnvoll, wenn die Aufzugsteuerung keine Schnittstelle zur Ausgabe der Kabinenposition aufweist.

Ein zweiter Aspekt der Erfindung betrifft eine Aufzuganlage mit einem derartigen Positionsbestimmungssystem.

Die Aufzuganlage weist insbesondere ein zweites Positionsbestimmungssystem auf, welches einer Aufzugsteuerung der Aufzuganlage eine Information über die Position der Aufzugkabine liefert und unabhängig vom ersten Positionsbestimmungssystem ausgeführt ist.

Die oben genannte Aufgabe wird gemäss einem dritten Aspekt der Erfindung durch ein Verfahren zur Ermittlung einer Kabinenposition einer in einem Aufzugschacht verfahrbaren Aufzugkabine gelöst, bei welchem

- eine an der Aufzugkabine anbringbare Erfassungsvorrichtung Codemarken eines parallel zu einer Verfahrrichtung neben der Aufzugskabine anbringbaren Codebands mit einem aus einzelnen Codemarken aufgebauten Codemarkenmuster erfasst und
- eine Auswerteeinheit die Kabinenposition auf Basis der von der Erfassungsvorrichtung erfassten Codemarken bestimmt,

wobei n aufeinanderfolgende Codemarken des Codemarkenmusters eine Positionsmarke bilden, die Positionsmarken in einer n-stelligen Pseudozufallsfolge verschiedener Positionsmarken eindeutig angeordnet sind, die Positionsmarken ein einspuriges Codemarkenmuster bilden und jeder Positionsmarke eine diskrete Kabinenposition zugeordnet ist.

Erfindungsgemäss weist ein Erfassungsbereich der Erfassungsvorrichtung eine Erfassungs-Länge in Verfahrrichtung auf, welche kleiner ist als eine Positionsmarken-Länge einer Positionsmarke in Verfahrrichtung. Die Erfassungsvorrichtung erstreckt sich damit in Verfahrrichtung nicht entlang einer kompletten Positionsmarke. Damit kann die Erfassungsvorrichtung gleichzeitig nur einen Teil einer Positionsmarke und somit keine komplette Positionsmarke auf einmal erfassen.

Erfindungsgemäss weist die Erfassungsvorrichtung wenigstens vier, insbesondere sechs in Verfahrrichtung hintereinander angeordnete Sensoren auf.

Die Auswerteeinrichtung setzt insbesondere bei einem Verlagern der Erfassungsvorrichtung gegenüber dem Codeband in Verfahrrichtung eine erfasste Positionsmarke aus nacheinander erfassten Codemarken des Codemarkenmusters zusammen.

Die im Folgenden beschriebenen Ausgestaltungen des Positionsbestimmungssystems gelten auf analoge Weise auch für das Verfahren zur Ermittlung einer Kabinenposition einer in einem Aufzugschacht verfahrbaren Aufzugkabine.

Die einzelnen Codemarken des Codebands können beispielsweise durch magnetische Pole gebildet sein. Es ist auch möglich, dass die Codemarken unterschiedliche Dielektrizitätszahlen aufweisen oder eine spezifische Farbe oder Helligkeit, wie beispielsweise weiss und schwarz aufweisen. Darüber hinaus können die Positionsmarken auf weitere Arten realisiert werden.

Die Erfassungsvorrichtung weist zur Erfassung der Positionsmarken mehrere Sensoren auf. Die Art des oder der Sensoren ist dabei auf die Ausführung der Positionsmarken abgestimmt, die Sensoren können beispielsweise als Hall-Sensoren, kapazitive Effekte erfassenden Sensoren oder optische Sensoren ausgeführt sein. Die Sensoren erfassen die Codemarken insbesondere berührungslos.

Die Auswerteeinrichtung verfügt insbesondere über einen programmierbaren Microcontroller, der die von der Erfassungsvorrichtung erfassten Informationen über die Codemarken auswertet, und über einen Speicher.

Die Zuordnung einer Positionsmarke zu einer Kabinenposition erfolgt insbesondere über eine in der Auswerteeinheit gespeicherte Zuordnungstabelle. Die Zuordnung könnte auch über einen geeigneten Algorithmus erfolgen. Die Genauigkeit bzw. Auflösung der so ermittelten Kabinenpositionen hängt dabei hauptsächlich von der Codemarken-Länge der Codemarken in Verfahrrichtung ab, wobei die so genannte Codierung des Codebands ebenfalls eine Rolle spielen kann. Die Codemarken-Länge kann beispielsweise zwischen 4 und 20 mm betragen, so dass die Genauigkeit bzw. Auflösung ebenfalls zwischen 4 und 20 mm beträgt. Bei einer unten beschriebenen Manchester-Codierung des Codebands beträgt die Genauigkeit bzw. Auflösung die doppelte Codemarken-Länge.

In einer Ausgestaltung der Erfindung ist die Erfassungs-Länge des Erfassungsbereichs der Erfassungsvorrichtung in Verfahrrichtung grösser als eine Codemarken-Länge, insbesondere grösser als zwei Codemarken-Längen. Die Erfassungsvorrichtung ist also so ausgeführt und angeordnet, dass sie zwei, insbesondere drei aufeinanderfolgende Codemarken des Codemarkenmusters gleichzeitig erfassen kann. Damit ist eine besonders sichere Bestimmung der Kabinenposition möglich.

Die Erfassungs-Länge des Erfassungsbereichs der Erfassungsvorrichtung in Verfahrrichtung ist dabei insbesondere nicht grösser als fünf, im Speziellen nicht grösser als vier und ganz speziell nicht grösser als drei Codemarken-Längen.

Die Codemarken bilden insbesondere magnetische Pole und die Erfassungsvorrichtung weist insbesondere Hall-Sensoren auf. Damit ist die Umsetzung des Positionsbestimmungssystems besonders kostengünstig.

In einer Ausgestaltung der Erfindung sind die Codemarkenmuster in Manchester-Codierung codiert. Damit wird sichergestellt, dass nach spätestens zwei aufeinanderfolgenden Codemarken ein Wechsel des Werts der Codemarke und damit auch ein Polwechsel stattfindet, was eine besonders genaue Bestimmung der Kabinenposition ermöglicht.

Die Erfassungsvorrichtung weist insbesondere mindestens sechs, insbesondere genau sechs Sensoren auf, die in einem Abstand kleiner als eine Codemarken-Länge einer Codemarke, insbesondere in einem Abstand einer halben Codemarken-Länge einer Codemarke in Verfahrrichtung angeordnet sind. Damit kann die Erfassungsvorrichtung aus den Signalen der Sensoren die Lage des Übergangs zwischen zwei verschiedenen Codemarken relativ zur Erfassungsvorrichtung bestimmen. Sie kann damit eine Interpolation zwischen zwei aufeinander folgenden Positionsmarken und damit zwischen zwei in der genannten Zuordnungstabelle abgelegten Kabinenpositionen durchführen. Der genannte Abstand bezieht sich dabei jeweils von Sensormitte zu Sensormitte in Verfahrrichtung.

Die Erfassungsvorrichtung kann damit analog einer in der EP 1412274 B1 beschriebenen Interpolationseinrichtung ausgeführt sein.

Das Codemarkenmuster ist insbesondere wie das Codemarkenmuster der EP 1412274 B1 ausgeführt.

Weitere Vorteile, Merkmale und Einzelheiten der Erfindung ergeben sich anhand der nachfolgenden Beschreibung von Ausführungsbeispielen sowie anhand der Zeichnungen, in welchen gleiche oder funktionsgleiche Elemente mit identischen Bezugszeichen versehen sind.

Dabei zeigen:

Fig. 1      eine schematische Darstellung einer Aufzuganlage mit einem Positionsbestimmungssystem zur Ermittlung einer Kabinenposition einer in einem Aufzugschacht verfahrbaren Aufzugkabine,

Fig. 2      eine schematische Darstellung eines Positionsbestimmungssystems und

Fig. 3      Sensorsignale von Sensoren einer Erfassungsvorrichtung des Positionsbestimmungssystems.

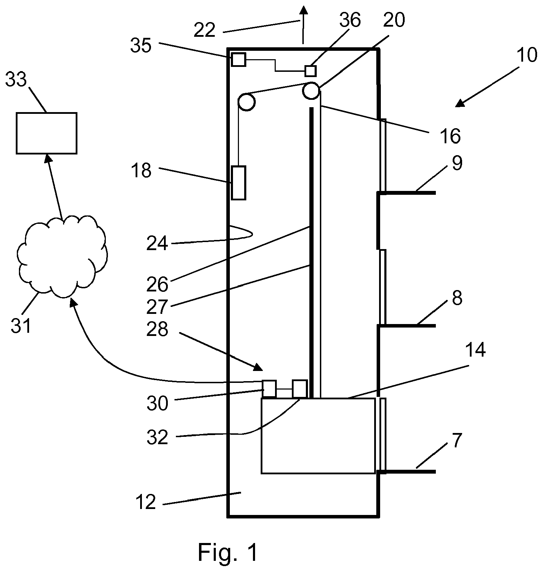

Gemäss Fig. 1 verfügt eine Aufzuganlage 10 über einen in vertikaler Richtung ausgerichteten Aufzugschacht 12. Innerhalb des Aufzugschachts 12 ist eine Aufzugkabine 14 angeordnet, welche über ein Tragmittel 16 in Form eines flexiblen Bands oder eines Seils mit einem Gegengewicht 18 auf bekannte Weise verbunden ist. Das Tragmittel 16 verläuft ausgehend von der Aufzugkabine 14 über eine Antriebsscheibe 20, welche von einer nicht dargestellten Antriebsmaschine angetrieben werden kann. Mittels der Antriebsmaschine und dem Tragmittel 16 kann die Aufzugkabine 14 im Aufzugschacht 12 auf und ab verfahren werden. Die Aufzugkabine 14 kann damit in oder entgegen einer Verfahrrichtung 22, welche in vertikaler Richtung nach oben verläuft, im Aufzugschacht 12 verfahren werden.

An einer Schachtwand 24 des Aufzugschachts 12 ist eine Führungsschiene 26 fixiert, die in Verfahrrichtung 22 verläuft. Beim Verfahren der Aufzugkabine 14 wird diese über nicht dargestellte Führungsschuhe entlang der Führungsschiene 26 geführt.

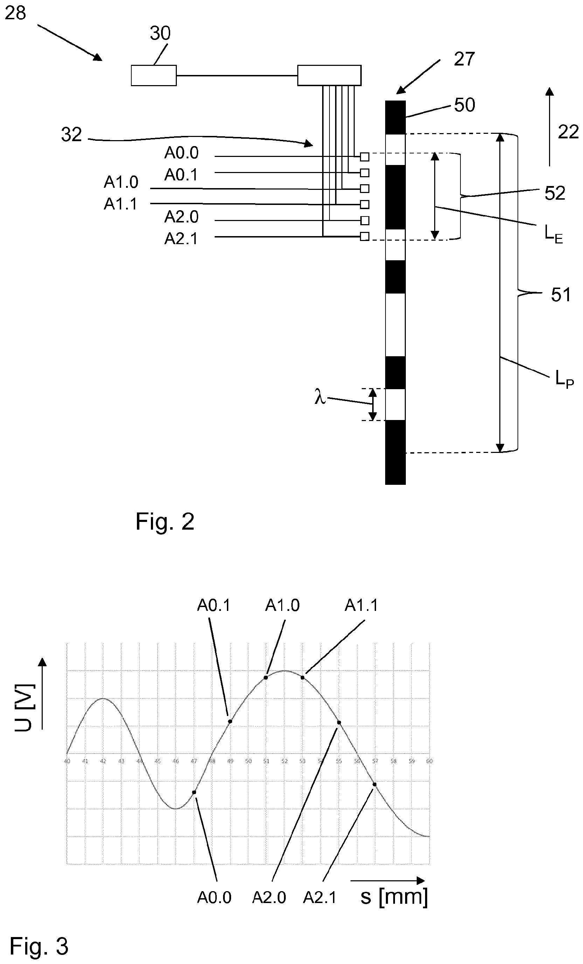

An der Führungsschiene 26 ist ein Codeband 27 in Form eines Magnetbands angeordnet, das in Fig. 2 detaillierter dargestellt ist und in Zusammenhang mit der Fig. 2 näher beschrieben wird. Das Codeband 27 dient als Träger für ein einspuriges kombiniertes Codemarkenmuster, das den numerischen Code von absoluten Positionen der Aufzugkabine 14 im Schacht 12 bezogen auf einen Nullpunkt darstellt. Das Codeband könnte auch unabhängig von einer Führungsschiene im Aufzugschacht angeordnet sein.

Auf der Aufzugkabine 14 sind Teile eines Positionsbestimmungssystem 28 zur Ermittlung einer Kabinenposition der Aufzugkabine 14 angeordnet. Das Positionsbestimmungssystem 28 verfügt über eine Auswerteeinheit 30 und eine Erfassungsvorrichtung 32, die auf der Aufzugkabine 14 angeordnet sind. Das Positionsbestimmungssystem 28 umfasst ausserdem das Codeband 27 und ist in Fig. 2 detaillierter dargestellt und wird in Zusammenhang mit der Fig. 2 näher beschrieben.

Die Erfassungsvorrichtung 32 ist so an der Aufzugkabine angeordnet, dass sie vom Codeband 27 gebildete Positionsmarken erfassen kann. Damit kann die Auswerteeinheit 30 und somit das Positionsbestimmungssystem 28 die Kabinenposition der Aufzugkabine 14 bestimmen.

In einer Konfigurationsphase wird die Aufzugskabine 14 so verlagert, dass alle Stockwerke 7, 8, 9 der Aufzuganlage 10 angefahren werden. Bei jedem Halt an einem der Stockwerke 7, 8, 9 speichert die Auswerteeinheit 30 die zu diesem Zeitpunkt erfasste Kabinenposition zusammen mit einer Stockwerksnummer des Stockwerks 7, 8, 9 ab. In einer nachfolgenden Überwachungsphase vergleicht die Auswerteeinheit 30 bei jedem Halt die aktuelle Kabinenposition mit der für das entsprechende Stockwerk 7, 8, 9 gespeicherten Kabinenposition. Das Ergebnis des genannten Vergleichs sendet die Auswerteeinrichtung 30 über eine Cloud 31 an eine entfernte Überwachungszentrale 33. Die Überwachungszentrale 33 überwacht die übermittelten Ergebnisse und löst beispielsweise bei zu grossen Abweichungen zwischen Kabinenpositionen bei einem Halt an einem Stockwerk 7, 8, 9 und der zugehörigen gespeicherten Kabinenposition eine entsprechende Meldung aus. Aufgrund dieser Meldung kann beispielsweise ein Servicetechniker die Aufzuganlage 10 überprüfen. Neben der beschriebenen Vorgehensweise der Überwachung der Kabinenposition gibt es viele weitere dem Fachmann bekannte Überwachungsmöglichkeiten, die für eine Überwachung der Kabinenposition verwendet werden können.

Die beschriebene Überwachung der Kabinenposition ist dabei unabhängig von einer im Aufzugschacht 12 angeordneten Aufzugsteuerung 35, welche die gesamte Aufzuganlage 10 ansteuert. Die Aufzugsteuerung 35 erhält dazu von einem zweiten, weiteren Positionsbestimmungssystem 36 eine Information über die Position der Aufzugkabine 14. Das weitere Positionsbestimmungssystem 36 bestimmt die Position der Aufzugkabine auf Basis einer Erfassung der Drehzahl der Antriebsscheibe 20 und ist damit unabhängig vom ersten Positionsbestimmungssystem 28. Die beiden Positionsbestimmungssysteme 28 und 36 bestimmen die Position der Aufzugkabine 14 somit unabhängig voneinander, sind nicht miteinander verknüpft oder signaltechnisch verbunden. Das genannte weitere Positionsbestimmungssystem 36, das der Aufzugsteuerung 35 eine Information über die Position der Aufzugkabine 14 liefert, kann auch auf eine andere, dem Fachmann als sinnvoll erachtete Weise ausgeführt sein.

Fig. 2 zeigt schematisch das Positionsbestimmungssystem 28 mit einem Teil des Codebands 27. Das Codeband 27 weist ein einspuriges kombiniertes Codemarkenmuster auf. Die einzelnen Codemarken 50 sind durch in Längsrichtung des Codebands 27 in einer Spur angeordnete gleichlange rechteckige Abschnitte mit einer Länge von jeweils $\lambda = 4$ mm symbolisiert und entweder als magnetischer Nordpol (weisses Rechteck) oder als magnetischer Südpol (schwarzes Rechteck) magnetisiert. Die einzelnen Nordpole und Südpole bilden nach aussen entsprechend orientierte Magnetfelder aus. Eine Codemarke wird hier auch als ein Bit bezeichnet. Die Codierung des Codebands 27 ist aufgebaut aus einer so genannten binären Pseudozufallsfolge. Eine Pseudozufallsfolge besteht aus lückenlos hintereinander angeordneten Bitsquenzen mit b binären Stellen. Bei jedem Weiterrücken um ein Bit in der binären Pseudozufallsfolge, stellt sich dann bekanntlich jeweils eine neue b-stellige binäre Bitsequenz ein. Eine solche Sequenz b hintereinander liegender Bits ist nachfolgend als Codewort bezeichnet.

Dem in der Fig. 2 dargestellten Beispiel des Codebands 27 liegt eine Pseudozufallsfolge aus Codeworten mit b=4 Stellen zu Grunde. Die Anzahl der Stellen kann auch deutlich höher sein, beispielsweise b=14 oder 16. In Verfahrrichtung 22 der beschriebenen Pseudozufallsfolge ist nach jedem Bit mit Wertigkeit "0" ein Bit mit der Wertigkeit "1" und nach jedem "1"-Bit ein "0"-Bit eingefügt. Folglich findet in dem einspurigen kombinierten Codemarkenmuster spätestens nach zwei Bits ein Bitwechsel statt. Diese Art der Codierung ist als sogenannte Manchester-Codierung bekannt. Auf dem Codeband 27 zeigt sich dies gemäss Fig. 2 dadurch, dass nur Magnetpole in der Länge $\lambda=4$ mm und der doppelten Länge von $2\lambda=8$ mm vorhanden sind und dass längstens nach $2\lambda=8$ mm ein Übergang von einem Nordpol auf einen Südpol oder umgekehrt auftritt. Durch die beschriebene Verdopplung der Bits wird bei gleichzeitiger Abtastung von jeweils $b+1=5$ aufeinanderfolgenden der jeweils zweiten Bits des kombinierten Codemarkenmusters ein eindeutiges 5-stelliges Ablesemuster ohne Wiederholung von Codeworten ausgelesen. Ein derartiges 5-stelliges Ablesemuster stellt damit eine im Aufzugschacht 12 angeordnete Positionsmarke 51 dar. Die Positionsmarke 51 setzt sich damit aus insgesamt zehn, d.h. n=10 aufeinander folgenden Codemarken 50 zusammen und weist eine Positionsmarken-Länge $L_P$ von $10 * \lambda = 40$ mm auf.

Die Erfassungsvorrichtung 32 zum Erfassen der Codemarken 50 verfügt über insgesamt sechs Hall-Sensoren A0.0, A0.1; A1.0, A1.1; A2.0; A2.1, welche in Verfahrrichtung 22 auf einer Linie mit einem Abstand einer halben Codemarkenlänge $\lambda/2=2$ mm angeordnet sind. Der Abstand bezieht sich dabei jeweils von Sensormitte zu Sensormitte in Verfahrrichtung 22. Die sechs Sensoren A0.0, A0.1; A1.0, A1.1; A2.0; A2.1 erstrecken sich damit in Verfahrrichtung 22 über mehr als zwei und weniger als drei Codemarken 50, womit insgesamt drei Codemarken 50 und damit weniger als zehn Codemarken 50 einer kompletten Positionsmarke 51 von der Erfassungsvorrichtung 32 erfasst werden können. Die jeweils äussersten Hall-Sensoren in Verfahrrichtung 22 A0.0 und A2.1 begrenzen damit einen Erfassungsbereich 52 der Erfassungsvorrichtung 32 in Verfahrrichtung 22. Der Erfassungsbereich 52 weist dabei eine Erfassungs-Länge $L_E$ in Verfahrrichtung auf. Die Erfassungs-Länge $L_E$ ist ein wenig grösser als das Fünffache des Abstands der Hall-Sensoren A0.0, A0.1; A1.0, A1.1; A2.0; A2.1 zueinander, also wenig grösser als $2.5 * \lambda = 10$ mm und damit deutlich kleiner als die Positionsmarken-Länge Lr = 40 mm.

Die sechs Hall-Sensoren A0.0, A0.1; A1.0, A1.1; A2.0; A2.1 der Erfassungsvorrichtung 32 bilden drei Sensorpaare (Ax.0, Ax.1). Steht einer der beiden Sensoren Ax.0, Ax.1 in der Nähe eines Magnetpolwechsels und liefert eine Sensorspannung von annähernd dem Wert Null, dann befindet sich der jeweils andere Sensor Ax.0 oder Ax. 1 mit Sicherheit in Abdeckung zu einem der Magnetpole und liefert eine sichere Information. Alle drei ersten Sensoren Ax.0 sind zu einer ersten Gruppe und alle drei zweiten Sensoren Ax.1 sind zu einer zweiten Sensorgruppe zusammengefasst. Von den Sensoren Ax.0 der ersten Sensorgruppe und der um die halbe Codemarkenlänge $\lambda/2=2$ mm in Verfahrrichtung 22 versetzten Sensoren Ax.1 der zweiten Sensorgruppe, werden alternierend immer nur die Ausgangssignale der Sensoren einer von beiden Sensorgruppen zur Erfassung der Codemarken 50 des Codebands 27 ausgewählt und ausgewertet.

Um eine komplette Positionsmarke 51 zu erfassen, muss die Erfassungsvorrichtung 32 und damit die Aufzugkabine 14 in oder gegen Verfahrrichtung 22 gegenüber dem Codeband 27 verlagert werden. Beim Verlagern setzt die Auswertevorrichtung 30 die erfasste Positionsmarke 51 aus den nacheinander erfassten Codemarken 50 zusammen. Sobald die Auswertevorrichtung 30 eine komplette Positionsmarke 51 zusammengesetzt hat, kann sie über eine gespeicherte Zuordnungstabelle die Kabinenposition bestimmen. Im in Fig. 2 dargestellten Beispiel ist dazu eine Verlagerung der Aufzugkabine 14 von ca. 40 mm notwendig.

Um eine genauere Kabinenposition zu bestimmen, detektiert die Auswerteeinrichtung 30 zusätzlich die quasi äquidistanten Polübergänge bzw. Nulldurchgänge des Magnetfelds zwischen zwei aufeinanderfolgenden Nordpolen oder Südpolen des Codemarkenmusters des Codebands 27.

In Fig. 3 ist ein Beispiel der Ausgangsspannungen der sechs Sensoren A0.0, A0.1; A1.0, A1.1; A2.0; A2.1 der Erfassungsvorrichtung 32 über dem Weg in Verfahrrichtung 22 in Millimeterabständen dargestellt. Die Spannungen der einzelnen Sensoren A0.0, A0.1; A1.0, A1.1; A2.0; A2.1 werden folgendermassen ausgewertet, wobei die Ziffer jeweils das Ergebnis der genannten Abfrage widergibt (0=> falsch, 1=> richtig):

$$U\,(A0.0) > 0 \qquad\qquad => 0$$

$$U\,(A0.0) + 1/3\; U(A0.1)\; > 0 \qquad => 0$$

$$U\,(A0.0) + U(A0.1)\; > 0 \qquad => 1$$

$$1/3\; U\,(A0.0) + U(A0.1)\; > 0 \qquad => 1$$

$$U(A0.1)\; > 0 \qquad\qquad => 1$$

usw.

$$U\,(A2.1) + 1/3\; U(A2.1)\; > 0 \qquad => 1$$

Dies ergibt für das in Fig. 3 dargestellte Beispiel die Ziffernfolge: 001111111111111111. Damit ist ausgedrückt, dass sich an dem ersten Hall-Sensor A0.0 bis 0.5 mm dahinter ein Südpol erstreckt. Ab 1.0 mm bis 9 mm hinter dem ersten Hall-Sensor A0.0 befindet sich ein Nordpol.

Die erzeugte Ziffernfolge wird über eine in der Auswerteeinheit 30 gespeicherten Tabelle in eine dreistellige binäre Zahlenfolge decodiert, die in dem dargestellten Beispiel eine so genannte interpolierte Kabinenposition von 3 mm darstellt. Diese ist mit der Codemarkenlänge λ periodisch und gibt die Polarität des Bandes von der Stelle des ersten Hall-Sensors A0.0 an gerechnet schrittweise in beispielsweise 0.5 mm Schritten an. Das höchstwertige Bit dieser interpolierten Kabinenposition invertiert in einem Abstand von 2 mm und übernimmt als Abtastsignal dient zur beschriebenen Umschaltung zwischen den Sensorgruppen der Erfassungsvorrichtung 32. Die so ermittelte interpolierte Kabinenposition wird zur oben beschriebenen Kabinenposition, die auf Basis der erfassten Positionsmarke 51 aus der Zuordnungstabelle ausgelesen wurde addiert. Das Ergebnis dieser Addition ist die von der Auswerteeinrichtung 30 bestimmte Kabinenposition, die für die oben beschriebene Überwachung der Anhaltegenauigkeit der Aufzugkabine 14 an den Stockwerken 7, 8, 9 verwendet wird.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Bezugszeichen in den Ansprüchen sind nicht als Einschränkung anzusehen.

## Patentansprüche

1. Positionsbestimmungssystem zur Ermittlung einer Kabinenposition einer in einem Aufzugschacht (12) verfahrbaren Aufzugkabine (14) mit

   - einem parallel zu einer Verfahrrichtung (22) neben der Aufzugskabine (14) anbringbaren Codeband (27) mit einem aus einzelnen Codemarken (50) aufgebauten Codemarkenmuster,
   - einer an der Aufzugkabine (14) anbringbaren Erfassungsvorrichtung (32) zum Erfassen von Codemarken (50) des Codemarkenmusters des Codebands (27) und
   - einer Auswerteeinheit (30) zur Bestimmung der Kabinenposition auf Basis der von der Erfassungsvorrichtung (32) erfassten Codemarken (50),
   wobei n aufeinanderfolgende Codemarken (50) des Codemarkenmusters eine Positionsmarke (51) bilden, die Positionsmarken (51) in einer n-stelligen Pseudozufallsfolge verschiedener Positionsmarken (51) eindeutig angeordnet sind, die Positionsmarken (51) ein einspuriges Codemarkenmuster bilden und jeder Positionsmarke (150) eine diskrete Kabinenposition zuordnenbar ist,
   **dadurch gekennzeichnet, dass**
   ein Erfassungsbereich (52) der Erfassungsvorrichtung (32) eine Erfassungs-Länge ($L_E$) in Verfahrrichtung aufweist, welche kleiner ist als eine Positionsmarken-Länge ($L_P$) einer Positionsmarke (51) in Verfahrrichtung (22) und

die Erfassungsvorrichtung (32) wenigstens vier, insbesondere sechs in Verfahrrichtung (22) hintereinander angeordnete Sensoren (A0.0, A0.1; A1.0, A1.1; A2.0; A2.1) aufweist..

2. Positionsbestimmungssystem nach Anspruch 1, **dadurch gekennzeichnet, dass**
   die Auswerteeinrichtung (30) dazu vorgesehen ist, bei einem Verlagern der Erfassungsvorrichtung (32) gegenüber dem Codeband (27) in Verfahrrichtung (22) eine erfasste Positionsmarke (51) aus nacheinander erfassten Codemarken (50) des Codemarkenmusters zusammenzusetzen.

3. Positionsbestimmungssystem nach Anspruch 1 oder 2, **dadurch gekennzeichnet, dass**
   die Erfassungs-Länge ($L_E$) des Erfassungsbereichs (52) der Erfassungsvorrichtung (32) in Verfahrrichtung grösser ist als eine Codemarken-Länge (λ), insbesondere grösser als zwei Codemarken-Längen (λ) ist.

4. Positionsbestimmungssystem nach einem der Ansprüche 1 bis 3, **dadurch gekennzeichnet, dass**
   die Codemarken (50) magnetische Pole bilden und dass die Erfassungsvorrichtung (32) Hall-Sensoren (A0.0, A0.1; A1.0, A1.1; A2.0; A2.1) aufweist.

5. Positionsbestimmungssystem nach einem der Ansprüche 1 bis 4, **dadurch gekennzeichnet, dass**
   das Codemarkenmuster in Manchester-Codierung codiert ist.

6. Positionsbestimmungssystem nach Anspruch 5, **dadurch gekennzeichnet, dass**
   die Erfassungsvorrichtung (32) mindestens sechs Sensoren (A0.0, A0.1; A1.0, A1.1, A2.0, A2.1) aufweist, die in einem Abstand kleiner als eine Codemarken-Länge (λ) einer Codemarke (50), insbesondere in einem Abstand einer halben Codemarken-Länge (λ/2) einer Codemarke (50) angeordnet sind.

7. Aufzuganlage, **dadurch gekennzeichnet, dass**
   die Aufzuganlage (10) ein erstes Positionsbestimmungssystem (28) nach einem der Ansprüche 1 bis 6 aufweist.

8. Aufzuganlage nach Anspruch 7, **dadurch gekennzeichnet, dass**
   die Aufzuganlage (10) ein zweites Positionsbestimmungssystem (36) aufweist, welches einer Aufzugsteuerung (35) der Aufzuganlage (10) eine Information über die Position der Aufzugkabine (14) liefert und unabhängig vom ersten Positionsbestimmungssystem (28) ausgeführt ist.

9. Verfahren zur Ermittlung einer Kabinenposition einer in einem Aufzugschacht (12) verfahrbaren Aufzugkabine (14), bei welchem

  - eine an der Aufzugkabine (14) anbringbare Erfassungsvorrichtung (32) Codemarken (50) eines parallel zu einer Verfahrrichtung (22) neben der Aufzugskabine (14) anbringbaren Codebands (27) mit einem aus einzelnen Codemarken (50) aufgebauten Codemarkenmuster erfasst und
  - eine Auswerteeinheit (30) die Kabinenposition auf Basis der von der Erfassungsvorrichtung (32, 132) erfassten Codemarken (50) bestimmt, wobei n aufeinanderfolgende Codemarken (50) des Codemarkenmusters eine Positionsmarke (51) bilden, die Positionsmarken (51) in einer n-stelligen Pseudozufallsfolge verschiedener Positionsmarken (51) eindeutig angeordnet sind, die Positionsmarken (51) ein einspuriges Codemarkenmuster bilden und jeder Positionsmarke (51) eine diskrete Kabinenposition zugeordnet ist,
  **dadurch gekennzeichnet, dass**
  ein Erfassungsbereich (52) der Erfassungsvorrichtung (32) eine Erfassungs-Länge ($L_E$) in Verfahrrichtung aufweist, welche kleiner ist als eine Positionsmarken-Länge ($L_P$) einer Positionsmarke (51) in Verfahrrichtung (22) und
  die Erfassungsvorrichtung (32) wenigstens vier, insbesondere sechs in Verfahrrichtung (22) hintereinander angeordnete Sensoren (A0.0, A0.1; A1.0, A1.1; A2.0; A2.1) aufweist.

10. Verfahren nach Anspruch 9,
  **dadurch gekennzeichnet, dass**
  die Auswerteeinrichtung (30) bei einem Verlagern der Erfassungsvorrichtung (32) gegenüber dem Codeband (27) in Verfahrrichtung (22) eine erfasste Positionsmarke (51) aus nacheinander erfassten Codemarken (50) des Codemarkenmusters zusammensetzt.

11. Verfahren nach Anspruch 9 oder 10,
  **dadurch gekennzeichnet, dass**
  die Erfassungsvorrichtung (32) mittels mindestens sechs Sensoren (A0.0, A0.1; A1.0, A1.1, A2.0, A2.1) Codemarkenübergänge erfasst und die Kabinenposition zusätzlich auf Basis der erfassten Codemarkenübergänge bestimmt.

## Claims

1. Position determination system for determining a car position of an elevator car (14) which can be moved in an elevator shaft (12), comprising

  - a code tape (27) that can be applied in parallel with a movement direction (22) next to the elevator car (14), comprising a code mark pattern constructed from individual code marks (50),
  - a detection device (32) which can be attached to the elevator car (14) for detecting code marks (50) of the code mark pattern of the code tape (27), and
  - an evaluation unit (30) for determining the car position on the basis of the code marks (50) detected by the detection device (32), n consecutive code marks (50) of the code mark pattern forming a position mark (51), the position marks (51) being unambiguously arranged in an n-digit pseudo-random sequence of different position marks (51), the position marks (51) forming a single-track code mark pattern and it being possible for each position mark (150) to be assigned a discrete car position,

  **characterized in that**

  a detection region (52) of the detection device (32) has a detection length ($L_E$) in the movement direction, which is smaller than a position mark length ($L_P$) of a position mark (51) in the movement direction (22), and
  the detection device (32) has at least four, in particular six sensors (A0.0, A0.1; A1.0, A1.1; A2.0; A2.1) arranged one behind the other in the movement direction (22).

2. Position determination system according to claim 1, **characterized in that**
  the evaluation apparatus (30) is provided to compile a detected position mark (51) from successively detected code marks (50) of the code mark pattern when the detection device (32) is moved relative to the code tape (27) in the movement direction (22).

3. Position determination system according to either claim 1 or claim 2,
  **characterized in that**
  the detection length ($L_E$) of the detection region (52) of the detection device (32) in the movement direction is greater than a code mark length ($\lambda$), in particular greater than two code mark lengths ($\lambda$).

4. Position determination system according to any of claims 1 to 3,
  **characterized in that**
  the code marks (50) form magnetic poles and **in that** the detection device (32) has Hall sensors (A0.0, A0.1; A1.0, A1.1; A2.0; A2.1).

5. Position determination system according to any of

claims 1 to 4,
**characterized in that**
the code mark pattern is encoded in Manchester coding.

6. Position determination system according to claim 5,
**characterized in that**
the detection device (32) has at least six sensors (A0.0, A0.1; A1.0, A1.1, A2.0, A2.1) which are arranged at a distance smaller than a code mark length ($\lambda$) of a code mark (50), in particular at a distance of half a code mark length ($\lambda/2$) of a code mark (50).

7. Elevator system,
**characterized in that**
the elevator system (10) has a first position determination system (28) according to any of claims 1 to 6.

8. Elevator system according to claim 7,
**characterized in that**
the elevator system (10) has a second position determination system (36) which provides an elevator controller (35) of the elevator system (10) with information about the position of the elevator car (14) and is designed independently of the first position determination system (28).

9. Method for determining a car position of an elevator car (14) which can be moved in an elevator shaft (12), in which

- a detection device (32) which can be attached to the elevator car (14) detects code marks (50) of a code tape (27) that can be applied in parallel with a movement direction (22) next to the elevator car (14), comprising a code mark pattern constructed from individual code marks (50), and
- an evaluation unit (30) determines the car position on the basis of the code marks (50) detected by the detection device (32, 132), n consecutive code marks (50) of the code mark pattern forming a position mark (51), the position marks (51) being unambiguously arranged in an n-digit pseudo-random sequence of different position marks (51), the position marks (51) forming a single-track code mark pattern and each position mark (51) being assigned a discrete car position,

**characterized in that**

a detection region (52) of the detection device (32) has a detection length ($L_E$) in the movement direction, which is smaller than a position mark length ($L_P$) of a position mark (51) in the movement direction (22), and
the detection device (32) has at least four, in particular six sensors (A0.0, A0.1; A1.0, A1.1; A2.0; A2.1) arranged one behind the other in the movement direction (22).

10. Method according to claim 9,
**characterized in that**
when the detection device (32) is moved relative to the code tape (27) in the movement direction (22), the evaluation apparatus (30) compiles a detected position mark (51) from successively detected code marks (50) of the code mark pattern.

11. Method according to either claim 9 or claim 10,
**characterized in that**
the detection device (32) detects code mark transitions by means of at least six sensors (A0.0, A0.1; A1.0, A1.1, A2.0, A2.1) and determines the car position additionally on the basis of the detected code mark transitions.

**Revendications**

1. Système de détermination de position permettant de définir une position de cabine d'une cabine d'ascenseur (14) pouvant être déplacée dans une cage d'ascenseur (12), comportant

- une bande codée (27) pouvant être montée parallèlement à un sens de déplacement (22) à côté de la cabine d'ascenseur (14) et comportant un motif de repères de code composé de repères de code (50) individuels,
- un dispositif de détection (32) pouvant être monté sur la cabine d'ascenseur (14) et permettant de détecter des repères de code (50) du motif de repères de code de la bande codée (27) et
- une unité d'évaluation (30) permettant de déterminer la position de cabine sur la base des repères de code (50) détectés par le dispositif de détection (32), dans lequel n repères de code (50) consécutifs du motif de repères de code forment un repère de position (51), les repères de position (51) sont disposés de manière univoque dans une séquence pseudo-aléatoire de n chiffres de différents repères de position (51), les repères de position (51) forment un motif de repères de code en une voie et une position de cabine discrète peut être associée à chaque repère de position (150),

**caractérisé en ce que**

une zone de détection (52) du dispositif de détection (32) présente une longueur de détection ($L_E$) dans le sens de déplacement qui est inférieure à une longueur de repère de position ($L_P$)

d'un repère de position (51) dans le sens de déplacement (22) et

le dispositif de détection (32) présente au moins quatre, en particulier six, capteurs (A0.0, A0.1 ; A1.0, A1.1 ; A2.0 ; A2.1) disposés les uns derrière les autres dans le sens de déplacement (22)..

2.  Système de détermination de position selon la revendication 1,
    **caractérisé en ce que**
    l'appareil d'évaluation (30) est prévu pour constituer, lors d'un déplacement du dispositif de détection (32) par rapport à la bande codée (27) dans le sens de déplacement (22), un repère de position (51) détecté à partir de repères de code (50) détectés successivement du motif de repères de code.

3.  Système de détermination de position selon la revendication 1 ou 2,
    **caractérisé en ce que**
    la longueur de détection ($L_E$) de la zone de détection (52) du dispositif de détection (32) dans le sens de déplacement est supérieure à une longueur de repère de code ($\lambda$), en particulier supérieure à deux longueurs de repère de code ($\lambda$).

4.  Système de détermination de position selon l'une des revendications 1 à 3,
    **caractérisé en ce que**
    les repères de code (50) forment des pôles magnétiques **et en ce que** le dispositif de détection (32) présente des capteurs à effet Hall (A0.0, A0.1 ; A1.0, A1.1 ; A2.0 ; A2.1).

5.  Système de détermination de position selon l'une des revendications 1 à 4,
    **caractérisé en ce que**
    le motif de repères de code est codé dans le codage Manchester.

6.  Système de détermination de position selon la revendication 5,
    **caractérisé en ce que**
    le dispositif de détection (32) présente au moins six capteurs (A0.0, A0.1 ; A1.0, A1. 1, A2.0, A2.1) qui sont disposés à une distance inférieure à une longueur de repère de code ($\lambda$) d'un repère de code (50), en particulier à une distance d'une demi-longueur de repère de code ($\lambda/2$) d'un repère de code (50).

7.  Installation d'ascenseur,
    **caractérisée en ce que**
    l'installation d'ascenseur (10) présente un premier système de détermination de position (28) selon l'une des revendications 1 à 6.

8.  Installation d'ascenseur selon la revendication 7,
    **caractérisée en ce que**
    l'installation d'ascenseur (10) présente un second système de détermination de position (36) qui fournit des informations concernant la position de la cabine d'ascenseur (14) à une commande d'ascenseur (35) de l'installation d'ascenseur (10) et est réalisé indépendamment du premier système de détermination de position (28).

9.  Procédé permettant de définir une position de cabine d'une cabine d'ascenseur (14) pouvant être déplacée dans une cage d'ascenseur (12), dans lequel

    - un dispositif de détection (32) pouvant être monté sur la cabine d'ascenseur (14) détecte des repères de code (50) d'une bande codée (27) pouvant être montée parallèlement à un sens de déplacement (22) à côté de la cabine d'ascenseur (14) et comportant un motif de repères de code composé de repères de code (50) individuels et
    - une unité d'évaluation (30) détermine la position de cabine sur la base des repères de code (50) détectés par le dispositif de détection (32, 132), dans lequel n repères de code (50) consécutifs du motif de repères de code forment un repère de position (51), les repères de position (51) sont disposés de manière univoque dans une séquence pseudo-aléatoire de n chiffres de différents repères de position (51), les repères de position (51) forment un motif de repères de code en une voie et une position de cabine discrète est associée à chaque repère de position (51),

    **caractérisé en ce que**

    une zone de détection (52) du dispositif de détection (32) présente une longueur de détection ($L_E$) dans le sens de déplacement qui est inférieure à une longueur de repère de position ($L_P$) d'un repère de position (51) dans le sens de déplacement (22) et

    le dispositif de détection (32) présente au moins quatre, en particulier six, capteurs (A0.0, A0.1 ; A1.0, A1.1 ; A2.0 ; A2.1) disposés les uns derrière les autres dans le sens de déplacement (22).

10. Procédé selon la revendication 9,
    **caractérisé en ce que**
    lors d'un déplacement du dispositif de détection (32) par rapport à la bande codée (27) dans le sens de déplacement (22), l'appareil d'évaluation (30) constitue un repère de position (51) détecté à partir de repères de code (50) détectés successivement du motif de repères de code.

**11.** Procédé selon la revendication 9 ou 10, **caractérisé en ce que** le dispositif de détection (32) détecte des transitions de repères de code au moyen d'au moins six capteurs (A0.0, A0.1 ; A1.0, A1.1, A2.0, A2.1) et détermine en outre la position de cabine sur la base des transitions de repères de code détectées.

Fig. 1

Fig. 2

Fig. 3

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1412274 B1
- EP 1634841 A1
- EP 1637493 A1
- WO 2013182644 A1